# EUROPEAN PATENT APPLICATION

(11) **EP 3 206 470 A1**
(43) Date of publication of application: **16.08.2017**
(21) Application number: 16155215.3
(22) Date of filing: 11.02.2016
(51) Int. Cl.: H05K 7/20

(54) **FRAME FOR HOLDING AN ELECTRONIC BOARD, HOUSING, AND RACK INCLUDING FRAME AND HOUSING**

(71) Applicant: FUJIKURA LTD., Koto-ku Tokyo (JP); Airbus Operations (S.A.S.), 31060 Toulouse Cedex 9 (FR)
(72) Inventor: SINGH, Randeep, Tokyo (JP); MOCHIZUKI, Masataka, Tokyo (JP); SAITO, Yuji, Tokyo (JP); REBEYROTTE, Vincent, 31770 Colomiers (FR); CARCONE, Jonathan, 31300 Toulouse (FR)
(74) Representative: Zacco GmbH

(57) **Abstract**

A frame for holding an electronic board and being inserted into a rail of a housing is provided. The frame includes a first supporting portion that is a heatsink including a plurality of fins and supports the electronic board, an edge portion that is fitted to the rail, at least one first heat pipe that is configured to be in contact with a heated area of the first supporting portion, the edge portion, and the rail, and one or more piezo fan(s) disposed in a vicinity of the first supporting portion.

## Description

### TECHNICAL FIELD

The present invention relates to a frame for holding an electronic board, a housing and a rack including the frame and the housing.

### BACKGROUND

In electronic systems, it is known that electronic components on an electronic board generate heat, which results in a temperature increase of the electronic components, which is then evacuated by forced or natural convection and/or by conduction and/or by radiation. The potential feared consequences can be an increase of failure rate (e.g. due to cracks propagation) leading to damage on such components and/or on surrounding ones. Therefore, the electronic boards are arranged within the housing and within the rack to generate ventilation and some ventilation means are installed. Furthermore, there are various structures provided in order to dissipate the heat outside of the electronic system. For example, conventional systems use a metallic die cast heatsink frame which is installed on the electronic board to collect and dissipate such heat.

In avionic applications, it is known, in particular by the document EP 2061296 A1, that a circuit board assembly has one or more heat pipes (one of biphasic technologies) to enhance cooling of the circuit board. The biphasic technologies are used to improve heat transfer within the heatsink in order to decrease the thermal gradient within the heatsink, and consequently allow to benefit from a heat exchange area of the heatsink as much as possible.

On the other hand, more and more powerful electric and electronic items are installed on aircraft, and the trend to increase heat flux density of components is expected to continue. Additionally, electronic technologies sustain a lower temperature range than in the past, and so, there are less and less components available in a higher temperature range or in other various fields. These items have a greater tendency to heat up and therefore hamper reliability, or simply discard implementation of COTS (Components Off The Shelf). In order to overcome these difficulties, efficient cooling devices are becoming one of the key drivers in the design of new aircraft systems and the incremental development thereof.

Aircraft systems affected by these developments include computers associated with integrated modular avionics (with cabinets and blades included), flight control, air and pneumatic systems, auto-pilot systems, communication, fuel management, power electronics for electrical power distribution, landing gear, onboard maintenance systems, engine controls and the like.

Using conventional heatsinks could generate overheating of these aircraft systems that could lead to feasibility showstoppers with conventional electronics technologies and associated thermal management devices, or to reduce their MTBF (Mean Time Before Failure) by leading failures which are showstoppers of the thermal management. Because of these risks of failures, the aerospace thermal specification needs more components for an extended range operation or for uprating the performance of the device, which may leads to an increase in cost.

Other failures may include breaks in packaging due to high temperature, creeping, and stress regulation; breaks in components due to thermal fatigue; failure of components due to, for example, Arrhenius law which depends on temperature; and degradation of electrical performance due to for example, parameter shifting (i.e. derating performances).

Cooling devices to be embedded in aircraft must be usable in environments subjected to high vibration and shock levels, to a wide range of temperature (such as, for example, -55°C to +85°C), and to variable changes in pressure, acceleration and altitude, and to Electro-Magnetism Environments (EMC).

Such control devices also must not leak any liquid, must have little or no impact on maintenance tasks (such as being, for example, easy to dismount), and must be compatible with new microprocessors or "smart" components (microprocessors, FPGA, ASIC, memories, and the like) which dissipate more power, with highly integrated systems (systems with high power density), and with different equipment architectures (such as, for example, a CPU board).

In this case, it is not reasonable to rely only on only piezo-fans, which are generally used for thermal management of electronic components, via forced convection. The piezo-fans are particularly useful for some microprocessors and components with "medium to high" power densities or useful to address thermal cases with poor convective heat transfer such that electronics are cooled in still air or subjected to a loss of a cooling condition, hence improving convective exchange. Moreover, such control devices must be able to withstand changes in delta pressure and altitude if installed in a non-pressurized zone or in unusual situations.

### SUMMARY OF THE INVENTION

As the performances of components and the like of electronic boards have increased (i.e. more computing power capabilities or more integration), current electronic boards generate more heat than first generation electronic boards, and often over smaller areas (i.e. local hotspots phenomena). Hence, there are some cases where conventional systems using a metallic die cast heatsink frame or heat pipes are not efficient enough to evacuate the heat if they are not arranged or combined properly with other technologies (e.g. with a piezo-fan technology).

With conventional thermal management solutions and associated cooling limitations, operating temperatures of semiconductor chips would operate close to their maximum operating conditions (hence reducing the reliability of the chips and increasing the failure rate of the board) or above the maximum allowable components temperatures (which is just not acceptable in terms of feasibility). Conventional systems have very low tolerance to poor convective environments (whether for electronics architectures without cooling supply operating in still air, or electronics with air-supply in normal operation, but having to sustain failure modes like loss of cooling operations).

The present invention provides a frame for holding an electronic board, a housing, and a rack comprising the frame and the housing, which can provide sufficient and effective cooling performance by dissipating the heat from the electronic board.

The first aspect of the present invention is a frame for holding an electronic board and being inserted into a rail of a housing. The frame comprises a first supporting portion that supports the electronic board, an edge portion that is fitted to the rail, and at least one first heat pipe configured to be in contact with a heated area of the first supporting portion, the edge portion, and the rail.

According to the first aspect of the present invention, the frame for holding an electronic board enables to effectively drain the generated heat by a biphasic mechanism over an entire area of an embedded heatsink baseplate, thereby reducing a thermal gradient into the embedded heatsink baseplate, and to benefit from an entire convective exchange area of the heatsink.

In a second aspect of the present invention, the frame may further comprise at least one second heat pipe configured to be in contact with the heated area and a non-heated area of the first supporting portion.

According to the second aspect of the present invention, the frame can dissipate the generated heat more effectively.

In a third aspect of the present invention, the frame may further comprise a second supporting portion that supports the electronic board, and at least one third heat pipe configured to be in contact with the first supporting portion and the second supporting portion.

According to the third aspect of the present invention, the frame can dissipate the generated heat effectively by using an additional surface area.

In a fourth aspect of the present invention, the frame may further comprise a loop heat pipe that comprises a vapor line, a liquid line, and an evaporator connecting the vapor line the liquid line.

According to the fourth aspect of the present invention, the frame can dissipate the generated heat effectively by using a longer heat pipe.

In a fifth aspect of the present invention, the first heat pipe is preferably a plate-shaped heat pipe.

According to the fifth aspect of the present invention, the frame is provided that can dissipate the generated heat effectively by using a larger surface area.

In a sixth aspect of the present invention, the first supporting portion is preferably a heatsink comprising a plurality of fins.

In a seventh aspect of the present invention, the plurality of fins is preferably a pin fin or a plate fin.

According to the sixth aspect or the seventh aspect of the present invention, the frame can dissipate the generated heat effectively by using fins which release heat in the air.

In an eighth aspect of the present invention, the frame may further comprise at least one or more piezo fan(s) disposed in a vicinity of the first supporting portion. According to the eighth aspect of the present invention, the frame can dissipate effectively the generated heat collected by the heatsink baseplate by using additional fins which improve the heat release capability.

In a ninth aspect of the present invention, the at least one or more piezo fan(s) is powered through a wire connected to a power source that may be set up on the frame.

According to the ninth aspect of the present invention, the frame can dissipate effectively the generated heat, especially when ventilation means are not functional. As the piezo fan(s) is(are) powered, the thermal flow is increased even if the electronic board is not ventilated

A tenth aspect of the present invention is a housing for accommodating at least one frame holding an electronic board. The housing comprises a case, at least one rail that is arranged at an inner bottom surface of the case and is configured to receive the frame inserted therein, and at least one fourth heat pipe that is arranged between the inner bottom surface and the rail and is configured to be in contact with and intersect with the rail.

According to the tenth aspect of the present invention, the housing can sufficiently and effectively dissipate the generated heat by a biphasic mechanism.

In an eleventh aspect of the present invention, the rail is preferably a heat pipe having a U-shaped cross-section.

According to the eleventh aspect of the present invention, the housing including the rail can transfer the heat effectively.

In an twelfth aspect of the present invention, the rail comprises side walls preferably configured to have a spring function and incline with respect to the normal line of the inner bottom surface.

According to the twelfth aspect of the present invention, the housing including the rail can transfer the heat effectively and can hold a frame.

In a thirteenth aspect of the present invention, the rail preferably has an L-shape and comprises a fifth heat pipe arranged at a side wall of the rail.

According to the thirteenth aspect of the present invention, the housing including the rail can transfer the heat more effectively.

In a fourteenth aspect of the present invention, the rail of the housing preferably comprises a pressure plate configured to face the fifth heat pipe and to press and hold the frame against said heat pipe.

In a fifteenth aspect of the present invention, the rail further comprises a screw member or a spring member preferably, and the pressure plate is preferably configured to press and hold the frame by applying contact pressure which is received from the screw member or the spring member.

According to the fourteenth aspect or the fifteenth aspect of the present invention, the housing including the rail can hold a frame securely.

In a sixteenth aspect of the present invention, the rail preferably comprises a U-shaped spring plate configured to face the fifth heat pipe and to press and hold the frame against said heat pipe. Thus, the frame is maintained within the housing rail thanks to sliding locks that allow to clamp the sliding devices when the board is plugged.

According to the sixteenth aspect of the present invention, the housing including the rail can hold a frame securely with a simple structure, such as sliding locks (also called a wedge-locked structure) for example.

In a seventeenth aspect of the present invention, the fourth heat pipe of the housing is preferably an L-shaped pipe that extends from the inner bottom surface to one of inner side surfaces of the case.

According to the seventeenth aspect of the present invention, the housing can sufficiently and effectively dissipate the generated heat and release said heat outside of the housing.

In an eighteenth aspect of the present invention, a plurality of the fourth heat pipes of the housing are preferably arranged alternatively so that the L-shaped pipe is reversed with respect to a normal line of the inner bottom surface of the case.

According to the eighteenth aspect of the present invention, the housing can sufficiently and effectively dissipate the generated heat as much as possible and release the heat outside of the housing.

In a nineteenth aspect of the present invention, the fourth heat pipe of the housing may further extend from the inner bottom surface to an inner top surface of the case.

According to the nineteenth aspect of the present invention, the housing can dissipate the generated heat more sufficiently and effectively and release the heat easily outside of the housing.

In a twentieth aspect of the present invention, a rack comprises the frame and the housing that accommodates the frame. The housing preferably comprises a case, at least one rail that is arranged at an inner bottom surface of the case and is configured to receive the frame inserted therein, and at least one fourth heat pipe that is arranged between the inner bottom surface and the rail and is configured to be in contact with and intersect with the rail.

According to the twentieth aspect of the present invention, the rack sufficiently and effectively dissipates and releases heat to maintain the operating performance of the components therein.

A twenty-first aspect of the present invention is a frame for holding an electronic board and being inserted into a rail of a housing. The frame may comprise a first supporting portion that is a heatsink comprising a plurality of fins and supports the electronic board, an edge portion that is fitted to the rail, at least one first heat pipe that is configured to be in contact with a heated area of the first supporting portion, the edge portion, and the rail, and one or more piezo fan(s) disposed in a vicinity of the first supporting portion.

According to the twenty-first aspect of the present invention, it is possible to remove the heat efficiently at the condenser located in the device by combining a piezo-fan with the biphasic technology. In addition, by disposing the heat pipe, the heatsink, and the piezo fan on a "replaceable frame" for a board such as a CPU board in accordance with the present aspect, "a primary cooling system along with the frame" can be in a form of a removable system. Therefore, the frame can be removed from a housing for consumer electronics such as computers, and the card supported by its frame is easily replaceable (inserted or removed from the housing for repair operations). The main advantage is to propose a frame allowing to simply plug or remove the board.

In a twenty-second aspect of the present invention, the first supporting portion of the frame for holding an electronic board and being inserted into a rail of a housing is a heatsink comprising a plurality of fins and supports the electronic board.

In a twenty-third aspect of the present invention, the one or more piezo fan(s) of the frame for holding an electronic board and being inserted into a rail of a housing is (are) powered through a wire connected to a power source that may be set up on the frame.

In a twenty-fourth aspect of the present invention, a rack comprises a frame for holding an electronic board and being inserted into a rail of a housing and the housing that accommodates the frame. The frame comprises a first supporting portion that is a heatsink comprising a plurality of fins and supports the electronic board, an edge portion that is fitted to the rail, at least one first heat pipe that is configured to be in contact with a heated area of the first supporting portion, the edge portion, and the rail, and one or more piezo fan(s) disposed in a vicinity of the first supporting portion. The housing comprises a case, at least one rail that is arranged at an inner bottom surface of the case and is configured to receive the frame inserted therein, and at least one fourth heat pipe that is arranged between the inner bottom surface and the rail and is configured to be in contact with and intersect with the rail.

According to the twenty-fourth aspect of the present invention, the rack dissipates and releases heat more sufficiently and effectively to maintain the operating performance of the components therein. In addition, by combining the heat pipe, which spreads heat over the frame and the heatsink, and a piezo fan which removes the heat from the frame and the heatsink to the air inside the rack, there is no need to include any cold sinks such as the water flow, a cold plate, or an air flow bay in the device. In accordance with such a structure, the aspect of the present invention can provide the thermal management of an electronic card operating in free convection (whether under normal mode, or for loss of cooling cases when equipment is supplied with coolant from the aircraft cooling system) under "loss of cooling condition".

In a twenty-fifth aspect of the present invention, the first supporting portion of the rack is a heatsink comprising a plurality of fins and supports the electronic board.

In a twenty-sixth aspect of the present invention, the one or more piezo fan(s) of the rack is (are) powered through a wire connected to a power source that may be set up on the frame.

### BRIEF DESCRIPTION OF THE DRAWINGS

Having thus described example implementations of the disclosure in general terms, reference will now be made to the accompanying drawings, which are not necessarily drawn to scale, and wherein:
- Fig. 1 is a schematic perspective view of a rack in accordance with one exemplary embodiment of the present invention.
- Fig. 2 is a schematic side view of a frame comprised in the rack of Fig. 1 in accordance with an exemplary embodiment of the present invention.
- Fig. 3 is a schematic side view of a frame comprised in the rack of Fig. 1 in accordance with another exemplary embodiment of the present invention.
- Fig. 4 is a schematic side view of a frame comprised in the rack of Fig. 1 in accordance with another exemplary embodiment of the present invention.
- Fig. 5 is a schematic side view of a frame comprised in the rack of Fig. 1 in accordance with another exemplary embodiment of the present invention.
- Fig. 6 is a schematic perspective view of a front surface (a) and a rear surface (b) of a frame comprised in the rack of Fig. 1 in accordance with another exemplary embodiment of the present invention.
- Fig. 7 is a schematic perspective view of a front surface (a) and a rear surface (b) of a frame comprised in the rack of Fig. 1 in accordance with another exemplary embodiment of the present invention.
- Fig. 8 is a schematic perspective view of a housing in accordance with one exemplary embodiment of the present invention.
- Fig. 9 is a schematic cross-sectional view of a rail in the housing in accordance with one exemplary embodiment of the present invention.
- Fig. 10 is a schematic cross-sectional view of a rail in the housing in accordance with another exemplary embodiment of the present invention.
- Fig. 11 is a schematic cross-sectional view of a rail in the housing in accordance with another exemplary embodiment of the present invention.
- Fig. 12 is a schematic perspective view of a housing in accordance with another exemplary embodiment of the present invention.

### DETAILED DESCRIPTION OF THE EMBODIMENTS

Hereinbelow, exemplary embodiments of the present invention are described with reference to the drawings. Similar elements are referred by the same numerical references unless they are particularly described.

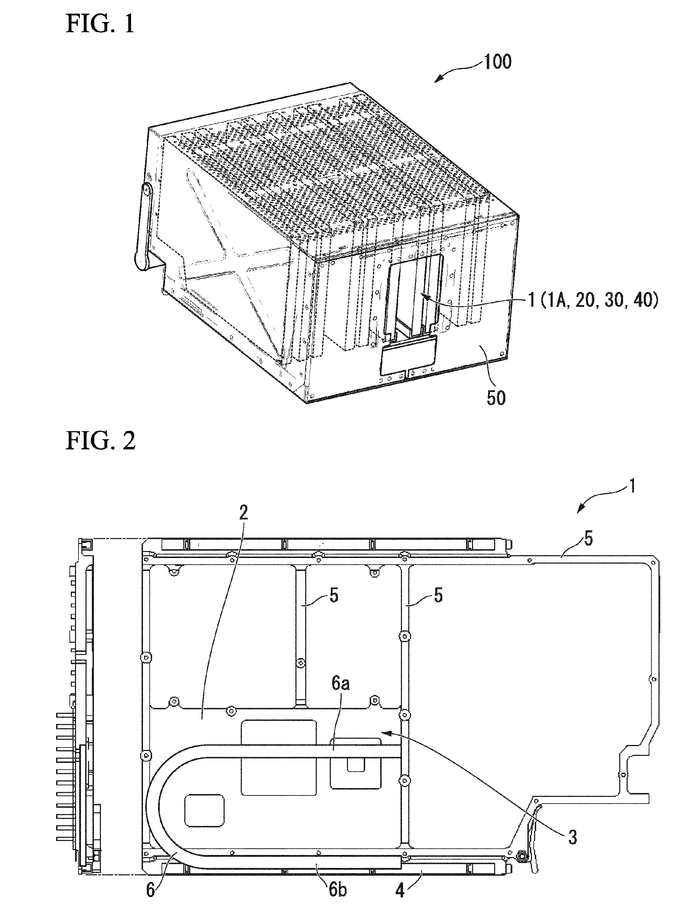

Fig. 1 is a schematic perspective view of a rack 100 that includes several frames 1 (in Fig. 1, ten frames 1 are shown) accommodated in a housing 50.

Fig. 2 is a schematic view in which a frame 1 is viewed from a front face and a side face. The frame 1 is capable of holding a board such as a printed circuit board. The frame 1 may be made of any material or combination of materials that has thermal conduction characteristics such as aluminum, copper, composites or any combinations thereof.

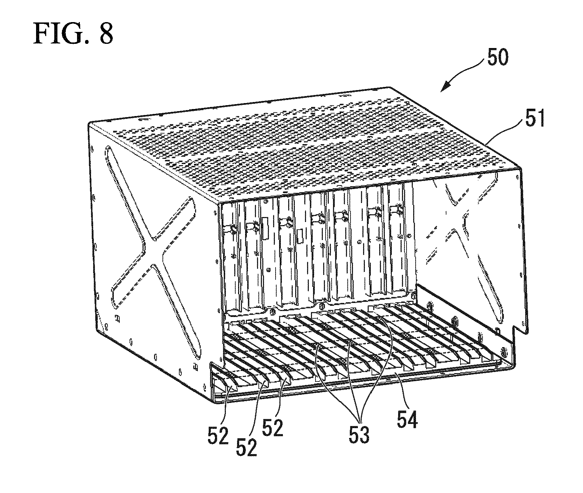

The frame 1 includes a first supporting portion 2 which includes a heated area 3 heated by a thermal contact with an electronic component generating heat such as a Central Processing Unit (CPU). The frame 1 further includes an edge portion 4 which is inserted into a rail 52 (see Fig. 8) of the housing 50 by sliding contact, and a supporting frame portion 5.

In addition, on a surface of the first supporting portion 2, a first heat pipe 6 is arranged such that one end portion 6a of the first heat pipe 6 is in contact with the heated area 3, and another end portion 6b of the same first heat pipe 6 is in contact with the edge portion 4 and also directly in contact with the rail 52. In the exemplary embodiments, the first heat pipe 6 may be any heat pipe known in the art. In view of the thermal diffusion, the first heat pipe 6 preferably has a U-shape; however, it is not limited to this shape. The first heat pipe 6 may be embedded in the frame 1 so as to obtain as much surface contact as possible in order to efficiently transfer the heat. Exposed portions of the first heat pipe 6 may have a flat surface.

Based on the structure of the frame 1, the generated heat can be transferred from the heated area 3 to the edge portion 4, and to the housing 50 through the rail 52.

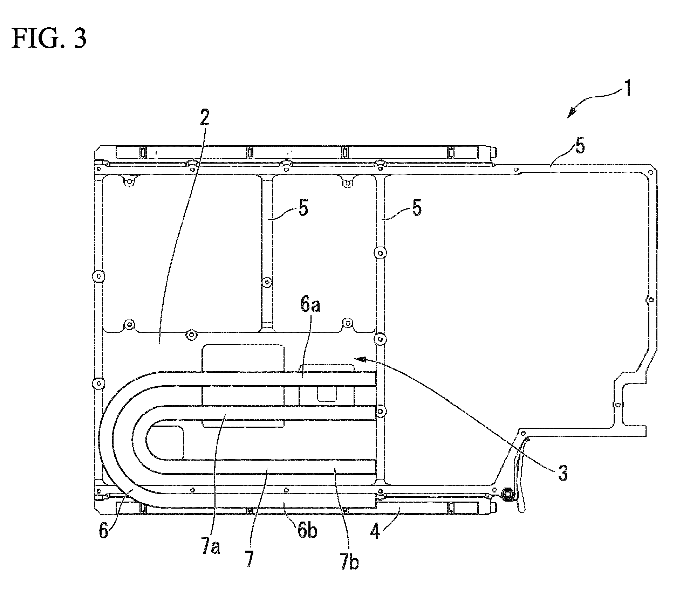

The frame 1A can further include a second heat pipe 7 as seen in Fig. 3. The second heat pipe 7 is arranged such that one end portion 7a of the second heat pipe 7 is in contact with the heated area 3 and another end portion 7b of the same second heat pipe 7 is in contact with the non-heated portion of the first supporting portion 2. In view of the thermal diffusion, the second heat pipe 7 also preferably has a U-shape; however, it is not limited to this shape. Similar to the first heat pipe 6, the second heat pipe 7 may be embedded in the frame 1 and exposed portions of the second heat pipe 7 may have a flat surface.

By using the first and second heat pipes 6 and 7 in combination, it is possible to diffuse and dissipate the heat generated by the electronic board more efficiently.

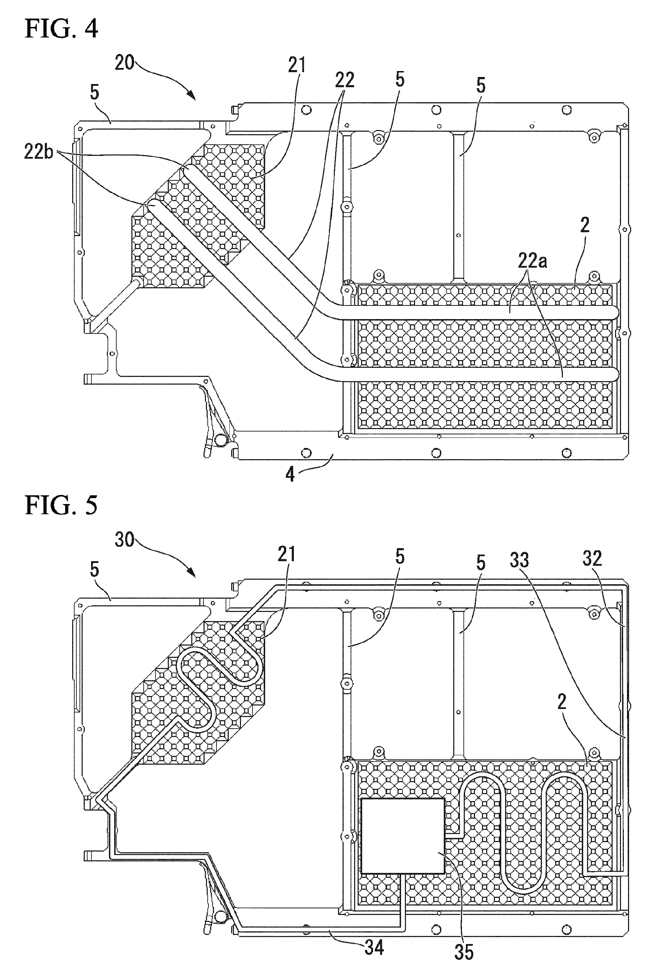

Fig. 4 shows a schematic view of a frame 20, which can be the opposite side of frame 1 or 1A and includes another example of heat pipe. The frame 20 differs from the frame 1 and 1A in that it includes a second supporting portion 21 which serves to dissipate the heat and reinforce the strength of the frame 20.

The frame 20 includes at least one third heat pipe 22 (In Fig. 4, two heat pipes 22 are shown) on its opposite surface. One end portion 22a of the third heat pipe 22 is in contact with the first supporting portion 2 and another end portion 22b of the third heat pipe 22 is in contact with the second supporting portion 21.

In a structure comprising the third heat pipe 22, the heat can be transferred to the available additional surface area of the frame 20. It is thus possible to diffuse and dissipate the generated heat more efficiently.

Fig. 5 shows a schematic view of a frame 30 including an example of a different heat pipe.

The frame 30 can include at least one loop heat pipe 32 arranged along the first supporting portion 2, the supporting frame portion 5, and the second supporting portion 21 to form a closed loop. The loop heat pipe 32 can include at least a vapor line 33, a liquid line 34, and an evaporator 35 connecting the vapor line 33 and the liquid line 34.

In a structure including the loop heat pipe 32 the heat can be transferred to a longer distance by utilizing available surface areas of the frame 30. It is thus possible to diffuse and dissipate the generated heat more efficiently.

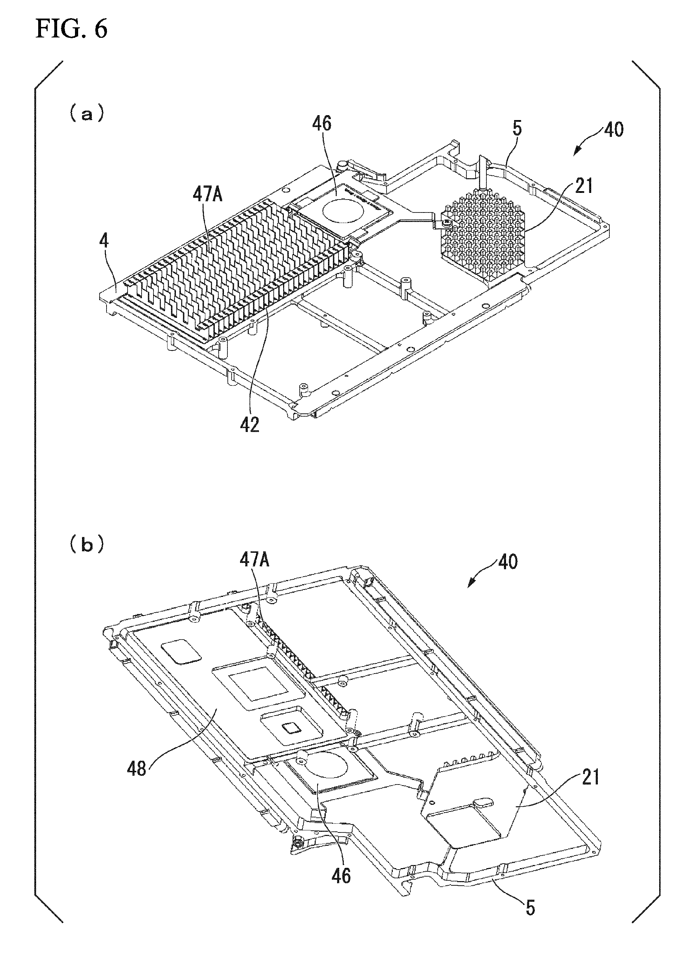

Fig. 6 shows a schematic perspective view of a frame 40. Fig. 6(a) shows an upper surface and Fig. 6(b) shows a lower surface of the frame 40. In the frame 40, the first supporting portion 42 and the second supporting portion 21 serve as heatsinks. At least the first supporting portion 42 is a finned heatsink and includes plate-shaped fins 47A on an upper surface of the first supporting portion 42. The frame 40 also includes at least one piezo fan 46. For example, in Fig. 6(a), the piezo fan 46 is placed in the vicinity of the finned heatsink so that the piezo fan 46 can provide an optimum air flow (i.e., expulsion or exhaust of an air) to the finned heatsink as well as it allows the finned heatsink to intake fresh air from outside of the rack with piezo-fans.

The at least one piezo fan 46 may be powered through a wire (for example) connected to a power source that may be set up on the frame 40.

The second supporting portion 21 shown in Fig. 6 includes pins; however, the configuration thereof is not limited to the pins.

The frame 40 further includes a plate-shaped heat pipe 48 (i.e. a vapor chamber) that substantially covers a lower surface of the first supporting portion 42 which is not a surface including the plate 47A stacked with fins. The plate-shaped heat pipe 48 allows to diffuse and dissipate the heat generated by the electronic board in several directions so as the evacuation of heat is more efficient.

Based on the structure of the frame 40, the assembly can diffuse and dissipate the generated heat effectively.

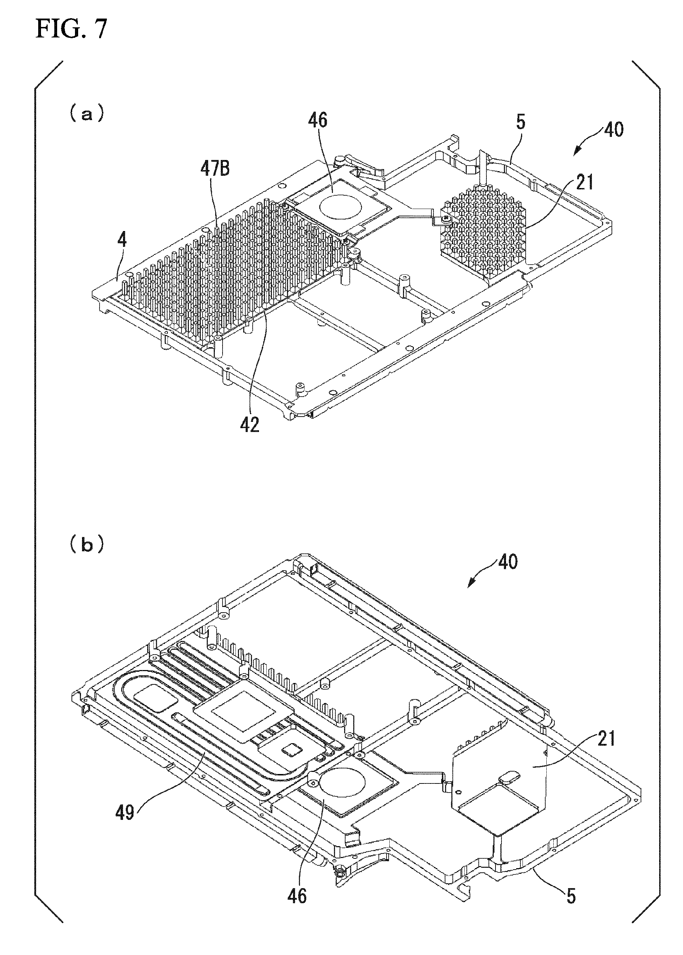

Fig. 7 shows a schematic perspective view of a frame 40 including another structural example. As shown in Fig. 7(a), the first supporting portion 42 may include a plate 47B stacked with pin fins. The first supporting portion 42 includes several heat pipes 49 arranged so as to cover the lower surface of the first supporting portion 42 as much as possible.

Fig. 8 shows a schematic perspective view of a housing 50 that accommodates any one of the frames 1, 1A, 20, 30, and 40 described above or any combination of the frames. The housing 50 includes a case 51, at least one rail 52 (in Fig.8, ten rails 52 are shown as an example) that is arranged at an inner bottom surface 54 of the case 51 and receives any one of the frames described above, and at least one fourth heat pipe 53 (in Fig.8, three heat pipes 53 are shown) that is arranged between the inner bottom surface 54 of the case 51 and the rail 52 and is in contact with and intersect with the rail 52.

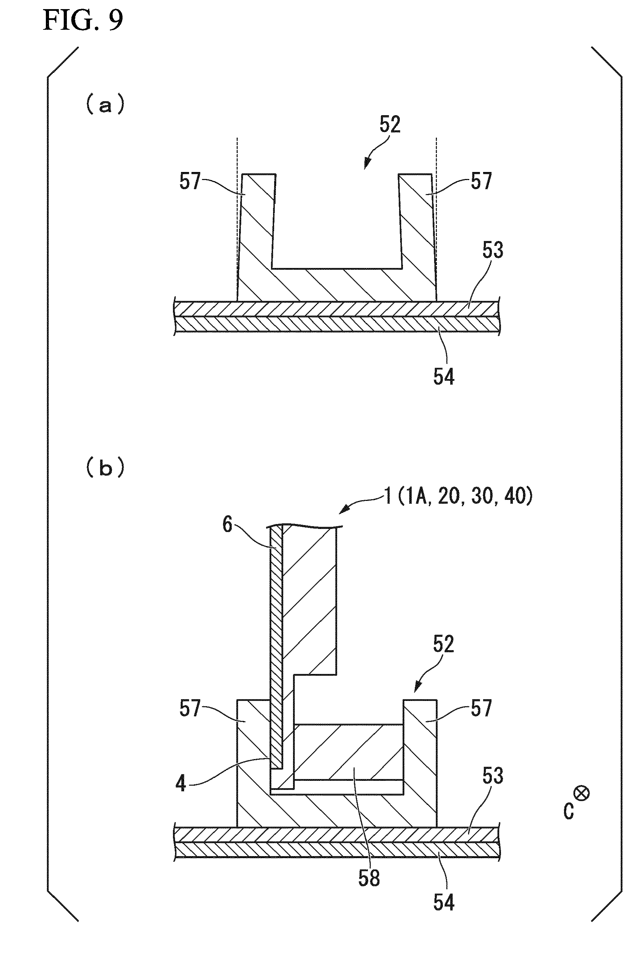

Fig. 9 shows a schematic cross-sectional view of an embodiment of the rail 52. As shown in Fig. 9(a), the rail 52 is a heat pipe having a U-shaped cross-section with two side walls 57. Such rail 52 can be made by folding two sides of a plate-like heat pipe, for example. The side walls 57 of the rail 52 have a spring function, and therefore, the side walls 57 are inclined with respect to a normal line (shown in dotted lines) of the inner bottom surface 54 toward a longitudinal center line of the rail 52. When the frame 1 is inserted into the rail 52 by a sliding motion in a direction shown by the reference sign "C" in Fig. 9(b), a sliding guide 58 attached to the frame 1 presses against the side walls 57 pushing them to align with the normal line. The side walls 57 apply an opposite force to the frame 1 and the sliding guide 58 holding the frame 1 in place inside the rail.

The heat pipe 6, the rail 52, and at least one fourth heat pipes 53 are directly in contact, thus the generated heat transferred from the first supporting portion 2 of the frame 1 (from the heated area 3 shown in Fig. 2 to the edge portion 4, for example) is further transferred to the rail 52, the fourth heat pipe 53, and the housing 50. Therefore, an effective path of heat dissipation is obtained.

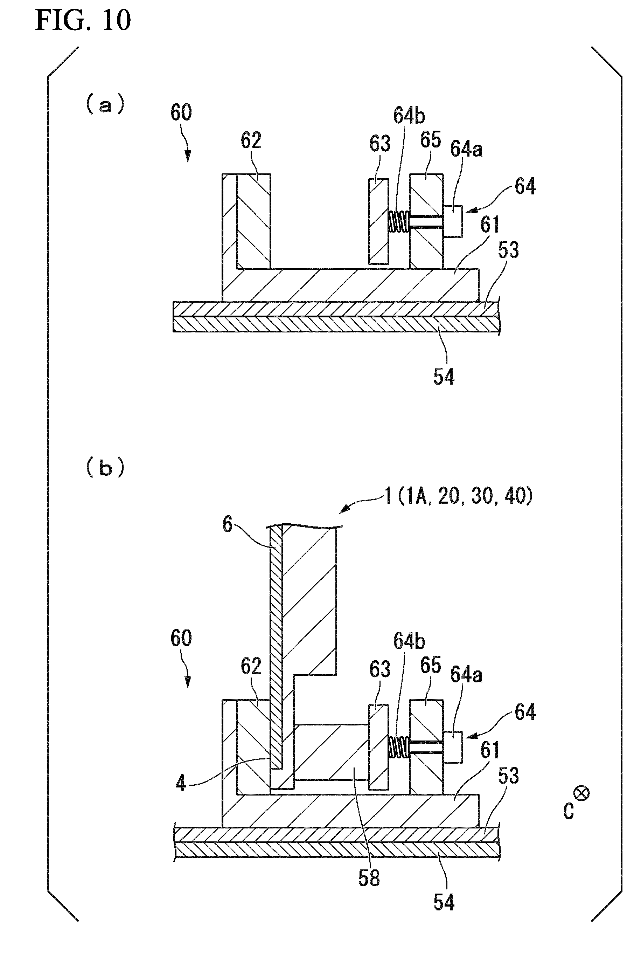

Fig. 10 shows a schematic cross-sectional view of a variant of the rail 52, the rail of this variant is referenced with number 60. In Fig. 10(a), the rail 60 includes an L-shaped rail body 61 and a fifth heat pipe 62 having a flat surface and arranged against a side wall forming the shorter branch of the L-shaped rail body 61. The fifth heat pipe 62 is embedded inside the side wall of the rail body 61, and an embedded surface of the fifth heat pipe 62 can be of a different geometry. Here, the fifth heat pipe 62 is not limited to be embedded, and may be disposed next to the side wall of the rail body 61.

The heat transferred from the first supporting portion 2 of the frame 1 is transferred to the fourth heat pipe 53 through the L-shaped body 61 and to the housing 50. Therefore, a path of heat dissipation is obtained.

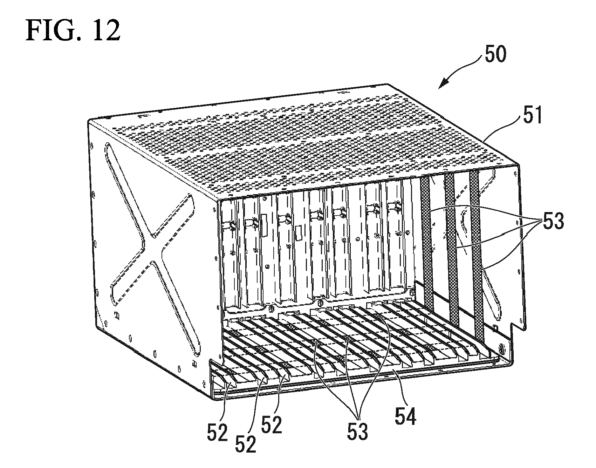

A variant of this configuration is shown on Fig. 12. The heat pipe 53 is extended to at least one of inner side surfaces of the case 51 so as to form an L-shape. Alternatively, the fourth heat pipe 53 may further be extended to an inner top surface of the case 51. In addition, a plurality of the L-shaped heat pipes is arranged alternatively so that the L-shape is reversed with respect to a normal line of the inner bottom surface 54.

In order to hold the frame 1 securely, the rail 60 includes a pressure plate 63 which presses and holds the frame 1 against the side of the fifth heat pipe 62 opposed to the side if the fifth heat pipe 62 in contact with the shorter branch of the L-shaped rail body 61.

The rail 60 may further include a spring member 64 having a head portion 64a and a spring portion 64b arranged between the pressure plate 63 and a plate 65 fixed perpendicularly on the longer branch of the L-shaped body 61. The head portion 64a is fixed to the plate 65. When the frame 1 is inserted into the rail 52 by a sliding motion in a direction shown by reference "C" in Fig. 10(b), the sliding guide 58 attached to the frame 1 presses on the pressure plate 63, and the spring member 64 presses back the pressure plate 63 by a spring pressure. As a result, the frame 1 can be securely held in the rail 60. As a variant, the spring member 64 can be a screw.

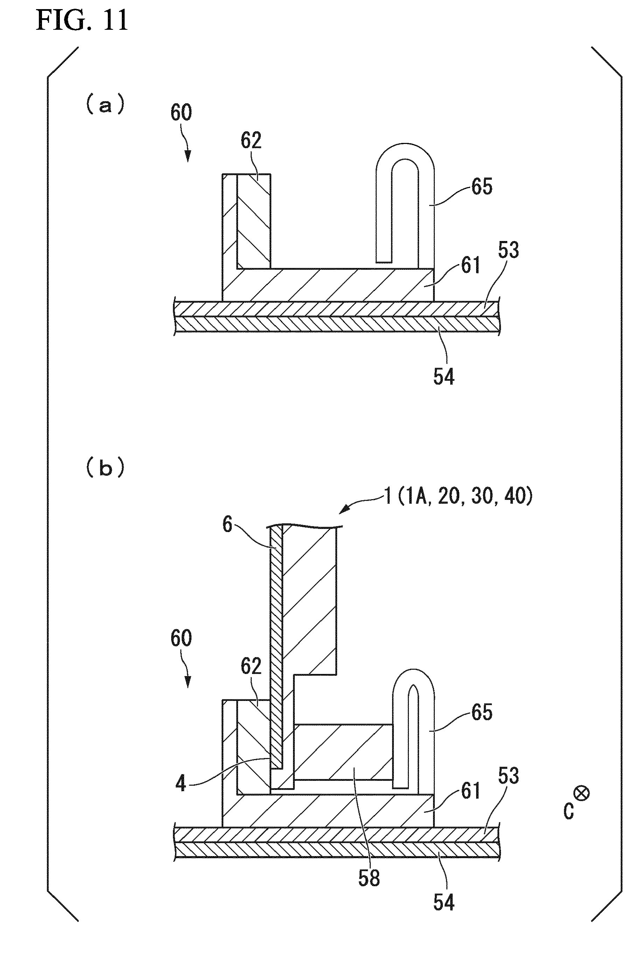

Alternatively, as shown in Fig. 11(a) and Fig. 11(b), instead of the pressure plate 63 and the spring member 64, the rail 60 may include a spring plate 65 directly applying the pressure to the frame 1 or the sliding guide 58 through a spring function. The spring plate 65 can have a U-shape with one of its extremities fixed to the longer branch of the L-shaped rail body 61 and the other extremity free and in regard of the frame 1.

In another embodiment, the frame 1 may be securely held in the rail 60 with a sliding lock device.

While preferred exemplary embodiments of the invention have been described and illustrated above, it should be understood that these are exemplary of the invention and are not to be considered as limiting. Additions, omissions, substitutions, and other modifications can be made without departing from the scope of the present invention.

Accordingly, the invention is not to be considered as being limited by the foregoing description, and is only limited by the scope of the appended claims.

### REFERENCE SIGNS LIST

1, 1A, 20, 30, and 40 frame
2 first area
3 heated area
4 edge portion
5 supporting frame portion
6, 7, 22, 49, 53, 62 heat pipe
6a, 6b, 7a, 7b, 22a, 22b end portion
21 second area
32 loop heat pipe
33 vapor line
34 liquid line
35 evaporator
42 first supporting portion
46 piezo fan
47A, 47B plate
48 plate-shaped heat pipe
50 housing
51 case
52, 60 rail
54 inner bottom surface
57 side wall
58 sliding guide
61 L-shaped rail body
63 pressure plate
64 spring member
64a head portion
64b spring portion
65 plate
100 rack

## Claims

1. A frame for holding an electronic board and being inserted into a rail of a housing, the frame comprising:
a first supporting portion that supports the electronic board;
an edge portion that is fitted to the rail; and
at least one first heat pipe that is configured to be in contact with a heated area of the first supporting portion, the edge portion, and the rail.

2. The frame according to claim 1, further comprising
at least one second heat pipe configured to be in contact with the heated area and a non-heated area of the first supporting portion.

3. The frame according to claim 1 or 2, further comprising:
a second supporting portion that supports the electronic board; and
at least one third heat pipe configured to be in contact with the first supporting portion and the second supporting portion.

4. The frame according to claim 1 or 2, further comprising
a loop heat pipe that comprises a vapor line, a liquid line, and an evaporator connecting the vapor line and the liquid line.

5. The frame according to claim 1,
wherein the first heat pipe is a plate-shaped heat pipe.

6. The frame according to any one of claims 1 to 5, wherein
the first supporting portion is a heatsink comprising a plurality of fins.

7. The frame according to claim 6, wherein
the plurality of fins is a pin fin or a plate fin.

8. The frame according to any one of claims 1 to 7, further comprising one or more piezo fan(s) disposed in a vicinity of the first supporting portion.

9. The frame according to claim 8, wherein the at least one piezo fan is powered through a wire connected to a power source that may be set up on the frame.

10. A housing for accommodating at least one frame holding an electronic board, the housing comprising:
a case;
at least one rail that is arranged at an inner bottom surface of the case and is configured to receive the frame inserted therein; and
at least one fourth heat pipe that is arranged between the inner bottom surface and the rail and is configured to be in contact with and intersect with at least one rail.

11. The housing according to claim 10,
wherein the rail is a heat pipe having a U-shaped cross-section with two side walls.

12. The housing according to claim 11,
wherein the side walls of the rail are configured to have a spring function and are inclined with respect to a normal line of the inner bottom surface.

13. The housing according to claim 10,
wherein the rail has an L-shape and comprises a fifth heat pipe arranged at a side wall of the rail.

14. The housing according to claim 13,
wherein the rail of the housing comprises a pressure plate configured to face the fifth heat pipe and to press and fix the frame against said heat pipe.

15. The housing according to claim 14, wherein the rail further comprises a screw member or a spring member, and the pressure plate is configured to press and hold the frame by applying contact pressure which is received from the screw member or the spring member.

16. The housing according to claim 13,
wherein the rail comprises a U-shaped spring plate configured to face the fifth heat pipe and to press and hold the frame against said heat pipe.

17. The housing according to any one of claims 10 to 16,
the fourth heat pipe of the housing is an L-shaped pipe that extends from the inner bottom surface to one of inner side surfaces of the case.

18. The housing according to claim 17,
a plurality of the fourth heat pipes of the housing is arranged alternatively so that the L-shaped pipe is reversed with respect to a normal line of the inner bottom surface of the case.

19. The housing according to any one of claims 9 to 18,
wherein the fourth heat pipe of the housing further extends from the inner bottom surface to an inner top surface of the case.

20. A rack comprising:
the frame according to any one of claims 1 to 8; and
the housing that accommodates the frame, the housing comprising;
a case;
at least one rail that is arranged at an inner bottom surface of the case and is configured to receive the frame inserted therein; and
at least one fourth heat pipe that is arranged between the inner bottom surface and the rail and is configured to be in contact with and intersect with the rail.

21. A frame for holding an electronic board and being inserted into a rail of a housing, the frame comprising:
a first supporting portion;
an edge portion that is fitted to the rail;
at least one first heat pipe that is configured to be in contact with a heated area of the first supporting portion, the edge portion, and the rail; and
one or more piezo fan(s) disposed in a vicinity of the first supporting portion.

22. The frame for holding an electronic board and being inserted into a rail of a housing according to claim 21, wherein the first supporting portion is a heatsink comprising a plurality of fins and supports the electronic board.

23. The frame for holding an electronic board and being inserted into a rail of a housing according to claim 21 or 22, wherein the at least one or more piezo fan(s) is(are) powered through a wire connected to a power source that may be set up on the frame.

24. A rack comprising:
a frame for holding an electronic board and being inserted into a rail of a housing, the frame comprising,
a first supporting portion,
an edge portion that is fitted to the rail,
at least one first heat pipe that is configured to be in contact with a heated area of the first supporting portion, the edge portion, and the rail, and
one or more piezo fan(s) disposed in a vicinity of the first supporting portion; and
the housing comprising,
a case,
at least one rail that is arranged at an inner bottom surface of the case and is configured to receive the frame inserted therein, and
at least one fourth heat pipe that is arranged between the inner bottom surface and the rail and is configured to be in contact with and intersect with the rail.

25. The rack according to claim 24, wherein the first supporting portion is a heatsink comprising a plurality of fins and supports the electronic board.

26. The rack according to claim 24 or 25, wherein the at least one or more piezo fan(s) is(are) powered through a wire connected to a power source that may be set up on the frame.
